# EUROPEAN PATENT APPLICATION

(11) **EP 2 846 447 A2**
(43) Date of publication of application: **11.03.2015**
(21) Application number: 14182937.4
(22) Date of filing: 29.08.2014
(51) Int. Cl.: H02M 1/38, H02M 7/5395

(54) **Dead-time minimization in PWM driven power converters**

(30) Priority: 30.08.2013 GB 201315521
(71) Applicant: Control Techniques Ltd, Newtown, Powys SY16 3BE (GB)
(72) Inventor: Webster, Antony John, Newtown, Powys SY16 3BE (GB); Hart, Simon David, Newtown, Powys SY16 3BE (GB)
(74) Representative: Smith, Jeremy Robert

(57) **Abstract**

A method is provided of determining a time interval between switching events for a switching device in a power converter, the switching device being for coupling a direct current (DC) source to provide an alternating current (AC) output at a particular switching frequency. The method comprises selecting an initial length of a time interval between a first switching event and a second, subsequent switching event for the switching device and obtaining a current measurement value for the switching device when the time interval between the first switching event and the second, subsequent switching event takes said initial length. The method further comprises changing the length of the time interval between the first switching event and the second, subsequent switching event and obtaining a current measurement value for the switching device when the length of the time interval is changed. The current measurement values which have been obtained are used to detect generation of a current in the switching device. It is then determined, from the change made to the length of the time interval and the current measurement values obtained, a length (t_{g}) of the time interval at which said generation of a current in the switching device occurs.

## Description

### Field

The present disclosure relates to an improved method and system for selecting a dead-time interval between switching events in a power converter.

### Background

The use of power inverters (also known simply as "inverters" or "drives") for conversion of DC (direct current) power to AC (alternating current) power is well known.

Many inverters use Pulse Width Modulation (PWM) to control the inverter output voltage. Typically, PWM inverter circuitry comprises three separate phases wherein switching between the three phases can create a sinusoidal (AC) output current from a DC input.

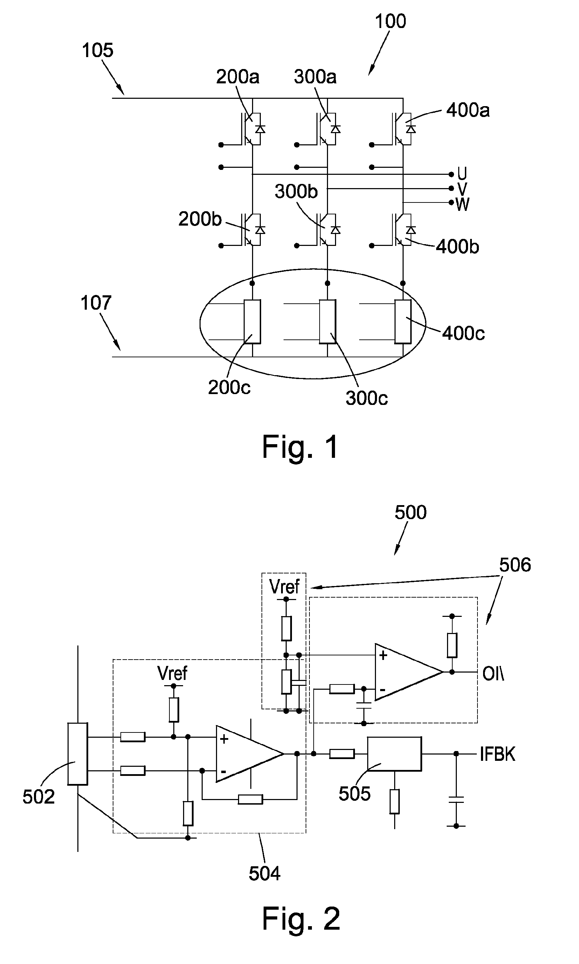

Figure 1 shows an inverter stage 100 that forms part of a known inverter. The inverter stage 100 comprises three separate phases or "legs" 200, 300, 400 (also referred to as phases U, V, W respectively). Each phase includes two switches in series: 200a, 200b in phase 200/U; 300a, 300b in phase 300/V; and 400a, 400b in phase 400/W. Switches 200a, 300a and 400a are connected to the positive rail 105 (and may be referred to as the "upper" switches) and switches 200b, 300b and 400b are connected to the negative rail 107 (and may be referred to as the "lower" switches). In Figure 1, each switch is an IGBT (Insulated Gate Bipolar Transistor). However, any other suitable power transistors may be used instead - including MOSFET, JFET and BJT. Any suitable control system, for example a microprocessor based solution, can be used to control the switching of the switches 200a, 200b, 300a, 300b, 400a, 400b to control the output of the inverter stage 100. Buffer circuits connecting a microprocessor to the power transistors are not shown in Figure 1 but may be included in such a circuit in order to provide isolation, level shifting and higher drive capability.

In Figure 1 the inverter stage 100 also includes three current measurement shunts, 200c, 300c, 400c - one in each phase, connected in series between the respective lower switch 200b, 300b, 400b and the negative rail 107. It is known to use current measurement shunts (also referred to as "shunt resistors"), such as the ones shown in Figure 1, in low to medium performance inverters in order to locate current feedback in the lower IGBT emitter switches. A typical feedback circuit used to sense shunt voltage is shown in Figure 2. One such feedback circuit is typically provided for each phase of an inverter stage 100.

As can be seen from Figure 2, the feedback circuit 500 includes a current measurement shunt 502 (which corresponds to one of the three current measurement shunts 200c, 300c, 400c shown in Figure 1), a fast differential amplifier 504 and a comparator circuit section 506 which provide fast short circuit detection. It also includes a sample and hold circuit section 505 for sampling signal for a micro-controller (or "microprocessor") A to D converter (not shown). The differential amplifier 504 and comparator circuit section 506 can compare the current measured for each phase 200, 300, 400 of the inverter stage, as detected by the respective current measurement shunts, 200c, 300c, 400c, to a hardware-defined threshold and generate a low logic signal if excessive current flows. Typically such a signal is processed by a local micro-controller (not shown) and buffer circuits (not shown) are employed to turn the inverter off quickly. Thus, over-current protection can be provided for the inverter stage 100 by the current measurement shunts 200c, 300c, 400c and their associated feedback circuits 500.

A sinusoidal AC output current can be created by the inverter stage 100 by controlling the switching states of the six switches 200a, 200b, 300a, 300b, 400a, 400b. Control schemes for controlling switching states in an inverter will be known to the skilled reader and will not be discussed further herein. An improved control scheme for modulating switching signals in a switching device of a power converter is described in GB patent application no. 1313576.9, in the name of Control Techniques Ltd., the entirety of which is incorporated herein by reference.

Typically, the inverter stage 100 must be controlled so that two switches in the same phase are never switched on at the same time. Thus, if 200a is on, 200b must be off and vice versa; if 300a is on, 300b must be off and vice versa; and if 400a is on, 400b must be off and vice versa. If both switches in a single phase or leg of the inverter stage 100 were to be switched on, a "shoot-through" current would be created in that leg. Shoot-through current is generally regarded as being undesirable and can be damaging to the circuit, for example causing the DC supply (not shown) to short circuit. Even small levels of shoot-through - which may not cause immediate damage to the inverter circuit - can still generate undesirable effects such as additional switching loss, higher temperatures and radiated emissions. It is therefore known to provide shoot-through protection in inverter circuitry. Shoot-through protection is often provided by the inclusion of a "dead-time" between switching events, which is a relatively short time interval during which both switches in an inverter leg are switched off. To illustrate; during switching of an inverter leg, dead-time will be included just after the upper switch has been switched off and before the lower switch is switched on, and vice versa. The dead-time provides a safeguard against inherent intolerances or delays in circuit components, which could otherwise cause both switches to effectively be switched on simultaneously if the lower switch was switched on immediately when the upper switch was switched off, or vice versa.

The inclusion of dead-time in a switching control scheme for an inverter can have detrimental effects including waveform distortion of the output current and a reduction in the level of output voltage that is attainable from the inverter. Therefore the choice of dead-time (i.e. the decision on how long the time interval should be) in a circuit such as the one shown in Figure 1 generally involves a compromise between accurate voltage production and shoot-through protection. The dead-time can, according to known methods, be selected and fixed (or "set") during product development testing. This means that all the inverter products within a manufacturing batch would be allocated the same dead-time, which typically leads to a dead-time value based on the worst possible conditions and batch tolerances and is hence longer than required for most products within the batch. An alternative is to determine an appropriate dead-time during inverter auto-tuning, on an individual product basis. However known methods for dead-time determination during auto-tuning are generally complex and require extensive computation.

An invention is set out in the claims.

According to a first aspect; a method is provided of determining a time interval between switching events for a switching device in a power converter, the switching device being for coupling a direct current (DC) source to provide an alternating current (AC) output at a particular switching frequency. The method comprises selecting an initial length of a time interval between a first switching event and a second, subsequent switching event for the switching device and obtaining a current measurement value for the switching device when the time interval between the first switching event and the second, subsequent switching event takes said initial length. The method further comprises changing the length of the time interval between the first switching event and the second, subsequent switching event and obtaining a current measurement value for the switching device when the length of the time interval is changed. The current measurement values which have been obtained are used to detect generation of a current in the switching device. It is then determined, from the change made to the length of the time interval and the current measurement values obtained, a length (t_{g}) of the time interval at which said generation of a current in the switching device occurs.

By changing the length of the time interval between switching events for the switching device of the power converter and looking at how such changes affect current in the switching device, effects such as the generation of shoot-through current can be detected. Furthermore, those effects may subsequently be accounted for-for example, by configuring the switching device to ensure that the length of time interval between switching events is always above a threshold, to avoid generation of shoot-through current.

The switching device may comprise a first switch and a second switch and wherein the first switching event comprises switching the first switch off and the second switching event comprises switching the second switch on, or vice versa. The step of detecting generation of a current in the switching device may comprise detecting a current flowing between said first and second switches. For example, it may comprise detecting a change in the amount of current flowing between the first and second switches. Such a change may be indicative of a shoot-through current in the switching device.

A third switching event may occur for the switching device, wherein that third switching event reverses the second switching event. A fourth switching event, subsequent to the third switching event, may reverse the first switching event. The length of a time interval between said third and fourth switching events may be selected and changed in order to be substantially equal to the length of the time interval between the first and second switching events, during operation of the switching device.

The method step of detecting generation of a current in the switching device may comprise detecting when a current measurement value for the switching device exceeds a threshold.

The switching device may comprise one or more switching legs, wherein said first switching event and said second switching event occur on the same switching leg. The switching device may comprises two or more switching legs, wherein each of said two or more switching legs comprises a pair of switches. The method may be repeated for each of the switching legs in the switching device.

The method may comprise the further step of, after the length (t_{g}) of the time interval at which said generation of a current in the switching device occurs has been determined, selecting an appropriate (or "improved") length (tₛ) of the time interval between the first switching event and the second switching event, wherein said selected length (tₛ) of the time interval is to be applied between switching events during subsequent operation of the power converter.

The step of selecting an improved length (tₛ) of the time interval between the first switching event and the second switching event may comprise applying a margin to the length (t_{g}) of the time interval at which said generation of a current in the switching device has been determined to occur. Such a margin may be applied in order to change the determined length (t_{g}) of the time interval to account for any of: testing error, the effect of temperature change on component behaviour, component ageing, component wear and tear, or variation between different components of the same type.

The steps required for determining of the length (t_{g}) of the time interval at which said generation of a current in the switching device occurs may be conducted during a tuning process for the power converter.

The method may comprise the step of, before the steps required for determining of the length (t_{g}) of the time interval at which said generation of a current in the switching device occur are conducted, changing a current detection threshold for the switching device. The change made to the current detection threshold for the switching device may be a temporary change. The change may be effected using any suitable means, for example using feedback circuitry connected to a current sensor in the switching device.

The step of determining a length (t_{g}) of the time interval at which said generation of a current in the switching device occurs may comprise determining a point at which said changed current detection threshold is exceeded. A circuit trip may occur in the switching device if the changed current detection threshold is exceeded.

According to a second aspect; an apparatus, system or device is provided for carrying out the method according to the first aspect.

According to a third aspect; a switching device for a power converter is provided, the switching device being for coupling a direct current (DC) source to provide an alternating current (AC) output at a particular switching frequency. The switching device is arranged to enable occurrence of at least a first switching event and a second, subsequent switching event, wherein a time interval occurs between said first switching event and said second, subsequent switching event. A length of said time interval is determined by selecting an initial length of the time interval between the first switching event and the second, subsequent switching event for the switching device and obtaining a current measurement value for the switching device when the time interval between the first switching event and the second, subsequent switching event takes said initial length. Thereafter, the determination includes changing the length of the time interval between the first switching event and the second, subsequent switching event and obtaining a current measurement value for the switching device when the length of the time interval is changed. The current measurement values which have been obtained are then used to detect generation of a current in the switching device and it is determined, from the change made to the length of the time interval and the current measurement values obtained, a length (t_{g}) of the time interval at which said generation of a current in the switching device occurs.

The switching device may be adapted, arranged or configured to enable some or all of of the method steps according to the first aspect to be performed.

The switching device may be comprised in a power converter, such as an inverter.

According to a fourth aspect; a computer, processor or controller is provided, adapted to perform some or all of the method steps according to the first aspect. A computer readable medium having computer-executable instructions may be adapted to cause a computer, processor or controller to perform some or all of the method steps according to the first aspect.

### Figures

Embodiments will now be described, by way of example only, with respect to the figures, of which:
Figure 1 shows known inverter stage circuitry including current measurement shunts;
Figure 2 shows a known current feedback circuit;
Figure 3 shows an improved current feedback circuit, including components for adjusting over-current trip level; and
Figure 4 shows the effects of changing a dead-time interval on peak emitter current for an inverter.

### Overview

In overview, an improved method and system are provided for determining an appropriate dead-time for an inverter or other power converter. The dead-time can be determined during a design and/or tuning process and then set for the subsequent operation of the power converter.

The dead-time is set as a time interval between successive switching events which occur on the same leg or phase of an inverter circuit. Each phase (or leg) will usually have two switches which are controlled so as not to be switched on simultaneously. The dead-time occurs after the first switch has been switched off, before the second switch is switched on, and vice versa.

The dead-time is determined based on the time interval that is required between switching events to ensure that both switches in the same leg are not effectively switched on simultaneously, taking in account factors such as component delay and temperature variation. Both switches being switched on simultaneously would lead to the generation of a shoot-through current in the inverter circuit. The improved method includes tuning a leg of the inverter circuit during a tuning process by reducing the dead-time interval, monitoring current for the inverter leg and detecting the "shoot-through point" - i.e. the point at which the dead-time interval is sufficiently short as to result in generation of a shoot-through current. The length (t_{g}) of the dead-time interval at the shoot-through point is referred to below as the "shoot-through dead-time". Factors such as component behaviour with temperature and time can then be taken into account by adding a margin (or correction factor) to the shoot-through dead-time. An improved dead-time (tₛ) is thus produced for the inverter leg. This improved dead-time (tₛ) can be applied between switching events during subsequent operation of the inverter.

Each leg of an inverter can be tuned individually to determine an appropriate dead-time for each leg. The longest dead-time from the determined individual dead-times can then be applied to every leg in the inverter circuit. Alternatively, a different respective dead-time can be set for two or more different legs in an inverter circuit.

During the tuning process, the effect on current of changing the dead-time for an inverter leg can be monitored using relatively simple current measurement components such as a shunt or other current sensor, connected to an appropriate feedback circuit. The improved method may include incorporating and/or controlling operation of suitable feedback circuitry in the inverter, to enable the shoot-through current that is generated during the tuning process to cause an over-current trip. The feedback circuitry can be arranged so that the over-current trip level is relatively low during the tuning process, so that the shoot-through point is detected, but is relatively high during subsequent operation of the inverter. This is to allow normal operation of the inverter, reducing unnecessary trips.

### Detailed Description

It has been recognised herein that relatively simple circuitry in a power inverter can be employed to determine an improved dead-time between switching events.

As described above in relation to Figure 1 and Figure 2, current measurement shunts 200c, 300c, 400c can be used to provide over-current protection in an inverter stage 100. Other components such as current transformers, GMR (Giant MagnetoResistive) sensors or Hall Effect sensors could be used instead of current measurement shunts. However, for illustrative purposes only, the following description will focus on the types of circuits shown in Figures 1 and 2, in which current measurement shunts 200c, 300c, 400c are used.

In operation, each current measurement shunt 200c, 300c, 400c in Figure 1 measures current in the lower switch 200b, 300b, 400b of the inverter stage phase 200, 300, 400 in which it is respectively connected and, with the aid of current feedback circuitry 500 such as that shown in Figure 2, compares the measured current to a threshold. The threshold for each current measurement shunt 200c, 300c, 400c is typically predefined by the intended load, taking into account the peak current that would be expected during overload, plus a margin, and is commonly referred to as the "over-current trip level" for that phase of the inverter. During normal operation of an inverter, the over-current trip level will generally be set, with a margin of error, to a level above the peak current that is expected to allow normal operation of the inverter, avoiding nuisance trips due to effects such as cable charging.

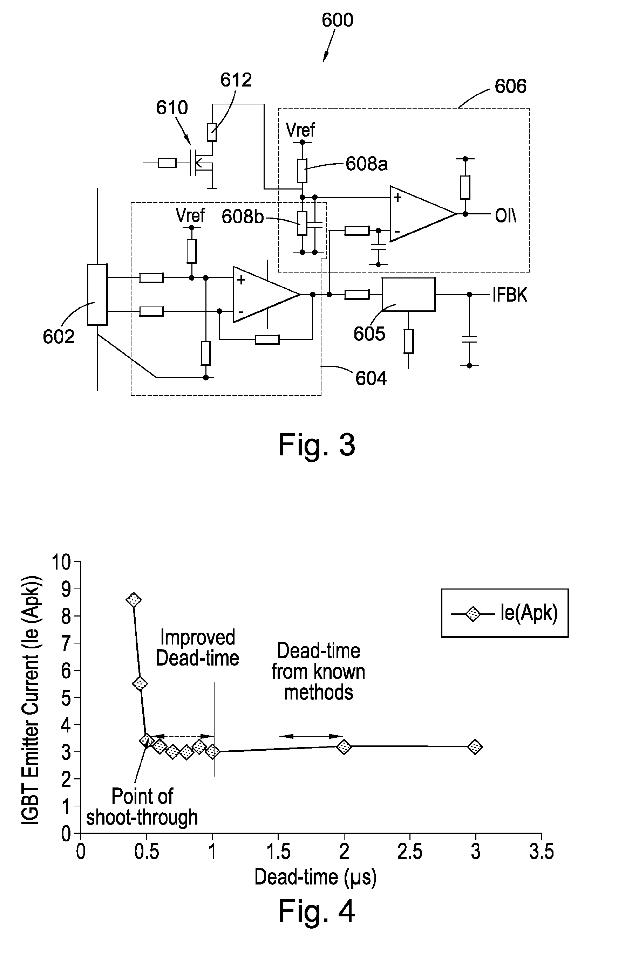

Figure 3 shows an improved current feedback circuit 600. As can be seen, the improved circuit 600 of Figure 3 comprises all the components shown in Figure 2 plus some additional components (circled in the top left hand corner of Figure 3) which enable the over-current trip level to be adjusted for the circuit 600. This adjustment is discussed further below. The improved current feedback circuit 600 of Figure 3 can connect to a current sensor - for example, to a current measurement shunt such as those shown in Figure 1 herein. Therefore the improved current feedback circuit 600 of Figure 3 can be used to provide over-current protection for an inverter stage and, as has been recognised herein, can also be used to measure the effect of shoot-through current in an inverter leg, which in turn can be used to determine an improved dead-time between switching events for the inverter.

According to an embodiment, an improved dead-time is determined for an inverter during a tuning process. The tuning process could be conducted by the manufacturer, before the inverter is sold or distributed to end users. Alternatively, the tuning process could be conducted by any other party such as the end user and could take place either before use of the inverter begins or after use of the inverter has already begun, in order to improve its subsequent operation.

According to an embodiment, the tuning process involves reducing the inverter dead-time and monitoring the effect which that reduction has on the peak emitter current for the inverter. In particular, the current is monitored to detect a generation of a shoot-through current. Once the length (t_{g}) of dead-time interval that gives rise to a shoot-through current (referred to herein as the "shoot-through dead-time") has been determined, an appropriate length (tₛ) of dead-time interval (referred to herein as the "improved dead-time") - which incorporates the shoot-through dead-time (t_{g}) plus any other suitable factors - is selected for the inverter. Typically, the tuning process will aim to minimise the improved dead-time (tₛ) as much as possible whilst ensuring that it does not give rise to a shoot-through current, or at least only gives rise to an acceptably low level of shoot-through current. Selection of the improved dead-time (tₛ) will, according to an embodiment, include providing a margin to account for any of: testing error, component intolerances and component wear and tear over time. According to an embodiment, the improved dead-time (tₛ) also factors in the effect of changing temperature on the operation of inverter components, as discussed further below.

The tuning process can be carried out, for example, for a circuit such as the inverter stage 100 shown in Figure 1. However, it will be appreciated that other inverter circuit types are possible and the tuning process could be applied to them. According to an embodiment, the tuning process is carried out for each phase 200, 300, 400 of the inverter stage 100 individually, with the other phases not switched, so that current will only flow through the inverter phase 200, 300, 400 under test during the tuning process. The inverter phase 200, 300, 400 under test is switched, for example at 50% duty, and the length of its dead-time interval is gradually reduced from a relatively high value (such as the hardware-determined value often used in known systems) down to lower value (t_{g}) at which the generation of a shoot-through current is detected. Once a shoot-through current has been detected, an improved dead-time (tₛ) can be selected for the respective phase and that improved dead-time (tₛ) can be set for subsequent operation of the inverter.

Figure 4 shows the typical effect on peak emitter current for a general purpose inverter as the dead-time interval is reduced during a turning process. The inverter used for the results of Figure 4 is a 400 Volts inverter, tested at room temperature; however it will be appreciated that the described tuning process can be applied analogously to other inverters. Looking again at Figure 4; it can be seen that the emitted current rises sharply when the dead-time for the inverter is below 0.5 microseconds. This current increase is due to shoot-through current being created as a result of short dead-time intervals between switching events. Therefore the value of the shoot-through dead-time (t_{g}) in this example is approximately 0.5 microseconds.

It can be seen from figure 4 that the dead time interval which would typically (using previously-known approaches) have been set for operation of the inverter under test would have been between 1.5 and 2 microseconds. This is significantly greater than 0.5 microseconds, which is determined, using the tuning process described herein, as being the shoot-through dead-time (t_{g}). As described in more detail below, even when time is added to that 0.5 microsecond value in order to account for factors such as component delay and temperature effects, the improved dead-time (tₛ) would be reasonably set - using the improved method described herein - at around, or even below, 1 microsecond. For example, in the circuit shown in figure 1, the temperature dependent margin for the IGBT emitters is likely to be of the order of 100 nanoseconds to 300 nanoseconds - this could be determined during development. Therefore using the improved method described herein results in a significant reduction of dead-time which, in turn, has a significant positive effect on the performance level of the inverter as a whole.

As mentioned above, according to an embodiment, the selection of an improved dead-time (tₛ) for an inverter takes the possible effects of temperature on the components of the inverter circuitry into account. The tuning process described herein can take place at any suitable temperature selected by the tester. For example, an inverter could be tested (or tuned) relatively quickly at room temperature during the manufacturing process to find the "shoot-through dead-time" (t_{g}) which results in generation of shoot-through current under those test conditions. Thereafter, a margin (or correction factor) can be incorporated into the improved dead-time (tₛ) to account for component variation due to the relatively higher temperatures that are likely to be experienced during inverter operation. In the example circuit of figure 1, the temperature factor would allow for increased IGBT temperature due to high ambient temperatures.

According to an embodiment in which the inverter switches comprise IGBT's, the tuning process to find the shoot-through dead-time (t_{g}) is conducted at no load since the component delays at no load lead to the need for a longer dead-time than the component delays would under load. This is because, as load reduces, the turn-off delay for a switch typically increases and the turn-on delay typically decreases, with the turn-off increase being more significant than the turn-on decrease.

According to an embodiment, dead-times are determined during the tuning process by measuring delays and current effects during pulse testing. In such embodiments, a relatively large safety margin is required in order to take into account possible device variability that may occur during normal inverter operation. As mentioned above, even when temperature factors and device variability margins are added to the measure of 0.5 microseconds for the shoot-through dead-time (t_{g}) in figure 4, allowing for increased delay of the IGBT of figure 1, the improved dead-time (tₛ) could still reasonably be set at, or even below, 1 microsecond. Therefore a dead-time reduction of around 0.5 microseconds as compared to prior art methods would be achieved.

The tuning process described herein can, according to an embodiment, be conducted individually for each inverter phase or leg, in order to determine an appropriate dead-time for each phase or leg. The highest dead-time value from the individual phases can then be selected as the interval between switching events on every such phase, to be used during subsequent normal inverter operation. Alternatively, the respective dead-time can be selected and set separately for each phase. Alternatively, the same dead-time can be selected and set for more than one (but not all) of the inverter phases.

The results shown in Figure 4 were conducted with the over-current trip level for the inverter being set at normal operational level, which in this particular example was 14A. The current shoot-through begins in Figure 4 when the dead-time is approximately 0.5 microseconds, and begins at a current level of approximately 3.2A and increases steeply thereafter as the dead-time interval is further reduced. Because the over-current trip level in the inverter used for Figure 4 was set at 14A, the generation of shoot-through current did not cause over-current trip. According to an embodiment, the over-current trip level can be temporarily reduced for the purpose of dead-time tuning, so that the start of shoot-through can cause a circuit trip and thereby be readily detected during the tuning process. This can enhance the convenience and accuracy of the tuning process, as it enables a clear determination of the "shoot-through dead-time" (t_{g}), at which shoot-through (or a particular, pre-selected level of shoot-through) is detected.

It will be appreciated that, in practice, there may be different possible ways in which the over-current trip level could be temporarily reduced for an inverter. The particular manner in which this temporary reduction is achieved can depend on factors such as cost, space, and the particular components present in the inverter circuitry - for example, the choice of current sensor and/or buffer circuits.

According to an embodiment, additional components can be included in the current feedback circuitry of an inverter to enable temporary reduction of the over-current trip level. For example, the additional components shown in the top left-hand corner of the improved feedback circuit 600 of Figure 3 can be incorporated into a conventional current feedback circuit such as the circuit 500 shown in Figure 2, in order to enable temporary reduction of the over-current trip level for the purpose of dead-time tuning. Although the particular components chosen in the circuit 600 of Figure 3 are just one example of circuitry that can achieve temporary reduction of over-current trip level for an inverter, they are discussed in more detail below for illustrative purposes.

In the improved feedback circuit 600 of Figure 3, the shunt resistor 602 (which can act as a current measurement shunt 200c, 300c, 400c in an inverter leg 200, 300, 400, as shown in Figure 1 herein) is dimensioned to as low a value as possible in order to minimise power dissipation. The corresponding current signal from the shunt resistor 602 is thus small and needs to be amplified to avoid problems with noise and to make it suitable for processing by analogue circuits and microprocessor A to D converters. The first stage of the feedback circuit in Figure 3 is therefore an operational-amplifier-based differential amplifier 604. It has a Gain to improve the size of the signal from the shunt resistor 602 and an off-set to allow a microprocessor (not shown) to measure currents flowing in both directions through the shunt resistor 602. The second stage of the feedback circuit in Figure 3 is a comparator 606, which is discussed further below. The circuit 600 also includes a sample and hold circuit section 605 for sampling signal for a microprocessor A to D converter (not shown).

During an over-current, the output of the differential amplifier 604 increases positively with a linear relationship to the current in the shunt resistor 602. The comparator 606 is used to monitor the output from the differential amplifier 604. When that output exceeds a voltage threshold (V_{ref}) set at the over pin of the comparator 606, it is arranged to change state to output low to indicate that an over-current has occurred. This is in turn detected by the microprocessor (not shown) which turns the PWM driving the IGBT switch off.

The voltage threshold (V_{ref}) for the comparator 606 is referred to earlier in this is disclosure as the "over-current trip level" for the inverter. It is set, in the circuit 600 of Figure 3, by a potential divider made of resistors 608a, 608b, usually from an accurate reference voltage. In order to enable temporary reduction of the voltage threshold (V_{ref}), the circuit 600 of Figure 3 includes a small MOSFET 610 to connect an extra resistor 612 into the bottom limb of the potential divider network 608a, 608b, thus lowering the voltage threshold (V_{ref}). This small MOSFET 610 can be controlled directly by the microprocessor (not shown) and thus turned on only during the tuning process. During subsequent normal operation of the inverter, once an appropriate dead-time (tₛ) has been selected and set, the MOSFET 610 can remain switched off and thus would not alter the comparator voltage threshold (V_{ref}).

Hence, as illustrated by the example above, a simple and cheap yet accurate means can be provided for altering the over-current trip level for the inverter for the purpose of dead-time tuning.

The extent to which the over-current trip level (or comparator voltage threshold V_{ref}) should be reduced for the dead-time tuning process will vary, dependent on the particular inverter set-up. The lower value, to which the over-current trip level is reduced, can be selected so as to be low enough to pick up small shoot-through effects but also high enough to avoid erroneous trips due to noise or currents pulses which are inherent to the circuit. For example, in some inverter products the gate driver circuit generates a pulse of current which is seen by the shunt resistors. The lower value of the over-current trip level should, if possible, be selected so that such pulses would not cause an over-current trip during the tuning process.

As mentioned previously, components other than those shown in Figures 1 to 3 herein can be used to monitor current signals emitted from a current sensor in an inverter circuit and to temporarily reduce an over-current trip level for the inverter circuit as part of the dead-time tuning process described herein. This notwithstanding, the circuit 600 shown in Figure 3 illustrates that such temporary reduction of the over-current trip level can be effected in a straight-forward, compact and cost-effective manner, using only a few components.

The improved method described herein for determining a suitable dead-time between switching events in an inverter is beneficial both to the inverter manufacturer and to the end user. As described in detail hereabove, relatively simple components, which are often already present in inverter circuits for other purposes, can be employed in order to monitor current at a low level, and determine the actual point of shoot-through for an inverter leg or phase. The particular examples described herein comprise three current measurement shunts - one connected to each of three legs in an inverter stage. However the improved method described herein could be applied to more complex circuit designs or to simpler, lower-cost circuit designs. For example, it could be applied to designs in which a single current measurement shunt (or other suitable current sensor) is located in the negative connection of the inverter, to sense current for all three inverter legs.

The improved method makes use of real measurements and does not rely on complex calculations. It thus provides a relatively simple, low cost solution. The selection of an improved dead-time (tₛ) can be based on actual parameters of an individual inverter in operation (in particular, on how long the dead-time should be in order to avoid or at least minimise shoot-through current on all legs of the inverter's circuitry), rather than being based on data-sheet worst case tolerances or on limitations which cover possible variation across all batches and can be over-conservative as compared with real variation within a batch.

When a dead-time interval for an inverter or other power converter is determined and subsequently set using the improved method described herein, the resulting power converter will typically be more robust in operation than other similar power converters for which dead-time has been determined using other methods. In operation, the power converter will experience less de-rating (particularly at low output frequency) and lower levels of shoot-through current. The improved dead-time also leads to better machine control, improved quality and lower field failure rate for the power converter. The improvement in machine control is attributable, at least in part, to the fact that dead-time intervals determined using the improved method are typically shorter than the dead-time intervals set for power converters using other methods. As is known, PWM is often used to control the three legs of an inverter stage, in order for its output waveform to be as close as possible to a sine wave. Dead-times effectively lead to gaps in the waveform, thereby distorting it away from the preferred sinusoidal form. By reducing the length of those gaps, the resultant waveform distortion is reduced, which in turn enables better control by the power converter. This is especially the case when the output voltage of the power converter is relatively low.

The improvement in quality and reliability of a power converter as a result of the improved method described herein is attributable, at least in part, to the reduction of the amount of shoot-through current generation that is permitted during operation of the power converter, once an improved dead-time has been determined and set. Even minor levels of shoot-through can lead to increased losses and/or temperature effects and can cause more inverter stress in high switching frequency applications - all of which can lead to early product failure. The improved method detects even low levels of shoot-through during the tuning process and enables selection of an appropriate, safe dead-time interval, which should prevent even such low levels of shoot-through current from being generated. Moreover, because the improved method comprises the determination of the real point of shoot-through for a power converter on an individual basis, it avoids setting an inappropriate dead-time value based on a limited sample size. The improved method also enables detection of anomalies that are missed by other methods - which typically rely on testing a few samples in order to determine parameters for an entire batch of products. For example, an opto-coupler within an inverter circuit could be operating out of specification, leading to shoot-through and failure in high frequency switching applications. As another example, making one small change of component choice for an inverter circuit might seem, on face value to the designer, to make no difference to the overall operation of that circuit but in practice it might cause shoot-through and lead to effects such as the product overheating. Such behaviours could be readily detected and accounted for using the improved method as described herein.

The improved method described herein can provide a low cost solution because it can be implemented using relatively few components - for example, a single sensor such as a current measurement shunt, current transformer, GMR sensor, or Hall Effect sensor can be employed per inverter or per inverter leg in order to monitor current and provide measurements to a respective feedback circuit. Other components may be used for current detection. For example, in a circuit such as the one shown in figure 1, an IGBT auxiliary emitter may be used for current detection. Particular examples of feedback circuits are shown in Figures 2 and 3; however any suitable current detection and feedback means may be employed.

A computer such as a general purpose computer can be configured or adapted to perform the described methods. In particular, a computer can be configured or adapted to control the reduction of the dead-time interval and/or the monitoring of the current measurement values during the described tuning process. According to an embodiment, the computer comprises a processor, a memory and a display. The computer can also comprise one or more input devices and/or a communications adapter for connecting the computer to other computers or networks. According to an embodiment, a processor such as a motor control microprocessor within a power converter is employed to control the dead-time reduction and tuning process.

An algorithm may be used to select and/or optimise a dead-time value for an inverter phase and/or for a number of inverter phases. The algorithm may combine the determination of the "shoot-through dead-time" (t_{g}), at which a non-zero shoot-through current is detected, with the incorporation of factors to account for real-world effects such as temperature variations and component ageing, in order to produce an improved dead-time value (tₛ) for an inverter phase or phases.

In operation, a computer or processor can be employed to execute computer executable instructions to perform part or all of the described method. Those computer executable instructions may be held in a computer or processor memory and the results of the processing may be displayed to a user on a display.

A computer readable medium such as a carrier disc or a carrier signal having computer executable instructions adapted to cause a computer to perform part or all of the described method may be provided.

The term "switching event" has been used herein as a general term for either the switching on or switching off of an IGBT emitter switch in the illustrated embodiments. However this term is also intended to cover the switching on or off of any other type of switch in an inverter or other power converter. Furthermore, another suitable term such as "logic pulse" may be used in place of the term "switching event".

Any relative terms such as "upper" and "lower" used herein are employed for illustrative purposes only and should not be regarded as limiting.

Particular circuits and embodiments have been described by way of example only. It will be appreciated that variations may be made. For example, the described method(s) could be applied to simpler current feedback circuits using just one shunt and/or to a simpler analogue circuitry.

## Claims

1. A method of determining a time interval between switching events for a switching device in a power converter, the switching device being for coupling a direct current (DC) source to provide an alternating current (AC) output at a particular switching frequency, the method comprising the steps of:
Selecting an initial length of a time interval between a first switching event and a second, subsequent switching event for the switching device;
Obtaining a current measurement value for the switching device when the time interval between the first switching event and the second, subsequent switching event takes said initial length;
Changing the length of the time interval between the first switching event and the second, subsequent switching event;
Obtaining a current measurement value for the switching device when the length of the time interval is changed;
Using the current measurement values obtained to detect generation of a current in the switching device;
Determining, from the change made to the length of the time interval and the current measurement values obtained, a length (t_{g}) of the time interval at which said generation of a current in the switching device occurs.

2. A method as claimed in claim 1 wherein the switching device comprises a first switch and a second switch and wherein the first switching event comprises switching the first switch off and the second switching event comprises switching the second switch on.

3. A method as claimed in claim 1 wherein the switching device comprises a first switch and a second switch and wherein the first switching event comprises switching the second switch off and the second switching event comprises switching the first switch on.

4. A method as claimed in claim 2 or claim 3 wherein a third switching event reverses the second switching event and a fourth switching event, subsequent to the third switching event, reverses the first switching event, and wherein the length of a time interval between said third and fourth switching events is selected and changed in order to be substantially equal to the length of the time interval between the first and second switching events, during operation of the switching device.

5. A method as claimed in any preceding claim wherein the step of detecting generation of a current in the switching device comprises detecting when a current measurement value for the switching device exceeds a threshold.

6. A method as claimed in any preceding claim wherein the switching device comprises a first switch and a second switch and wherein the step of detecting generation of a current in the switching device comprises detecting a current flowing between said first and second switches, wherein, optionally, the step of detecting a current flowing between said first and second switches comprises detecting a change in the amount of current flowing between said first and second switches.

7. A method as claimed in any preceding claim wherein the switching device comprises one or more switching legs, wherein said first switching event and said second switching event occur on the same switching leg.

8. A method as claimed in any preceding claim wherein the switching device comprises two or more switching legs, wherein each of said two or more switching legs comprises a pair of switches, wherein, optionally, the steps of claim 1 are repeated for each of the switching legs.

9. A method as claimed in any preceding claim further comprising the step of, after the steps of claim 1 have been conducted, selecting a length (tₛ) of the time interval between the first switching event and the second switching event, wherein said selected length (tₛ) of the time interval is to be applied during subsequent operation of the power converter.

10. A method as claimed in claim 9 wherein the step of selecting a length (tₛ) of the time interval between the first switching event and the second switching event comprises applying a margin to the determined length (t_{g}) of the time interval at which said generation of a current in the switching device has been determined to occur, wherein, optionally, the margin is applied in order to change the determined length (t_{g}) of the time interval to account for any of: testing error, the effect of temperature change on component behaviour, component ageing, component wear and tear, or variation between different components of the same type.

11. A method as claimed in any preceding claim wherein the steps required for determining of the length (t_{g}) of the time interval at which said generation of a current in the switching device occurs are conducted during a tuning process for the power converter.

12. A method as claimed in any preceding claim, further comprising the step of, before the steps required for determining of the length (t_{g}) of the time interval at which said generation of a current in the switching device occur are conducted, changing a current detection threshold for the switching device, wherein, optionally, the change made to the current detection threshold for the switching device is a temporary change, wherein, optionally, the step of determining a length (t_{g}) of the time interval at which said generation of a current in the switching device occurs comprises determining a length (t_{g}) of the time interval at which said changed current detection threshold is exceeded, wherein, optionally, during conductance of the steps required for determining of the length (t_{g}) of the time interval at which said generation of a current in the switching device occurs, a circuit trip will occur in the switching device if the changed current detection threshold is exceeded.

13. A switching device for a power converter, the switching device being for coupling a direct current (DC) source to provide an alternating current (AC) output at a particular switching frequency, the switching device being arranged to enable occurrence of at least a first switching event and a second, subsequent switching event, wherein a time interval occurs between said first switching event and said second, subsequent switching event, wherein a length of said time interval is determined by:
Selecting an initial length of the time interval between the first switching event and the second, subsequent switching event for the switching device;
Obtaining a current measurement value for the switching device when the time interval between the first switching event and the second, subsequent switching event takes said initial length;
Changing the length of the time interval between the first switching event and the second, subsequent switching event;
Obtaining a current measurement value for the switching device when the length of the time interval is changed;
Using the current measurement values obtained to detect generation of a current in the switching device;
Determining, from the change made to the length of the time interval and the current measurement values obtained, a length (t_{g}) of the time interval at which said generation of a current in the switching device occurs.

14. A power converter comprising a switching device as claimed in claim 13.

15. A computer readable medium having computer-executable instructions adapted to cause a computer, processor or controller to perform a method of any of claims 1 to 12.
